# EUROPEAN PATENT APPLICATION

(11) **EP 0 692 551 A1**
(43) Date of publication of application: **17.01.1996**
(21) Application number: 95304791.7
(22) Date of filing: 10.07.1995
(51) Int. Cl.: C23C 14/04, C23C 14/34, H01L 21/768

(54) **Sputtering apparatus and methods**

(30) Priority: 15.07.1994 US 275829
(71) Applicant: APPLIED MATERIALS, INC., Santa Clara California 95054-3299 (US)
(72) Inventor: Xu, Zheng, Foster City, California 94404 (US)
(74) Representative: Bayliss, Geoffrey Cyril

(57) **Abstract**

A sputtering apparatus deposits a material layer on a substrate (12) in multiple sub-layers to provide a desired uniform consistency in the deposition layer. The apparatus includes means for positioning the substrate in at least two positions (16,18) with respect to a sputtering target (14), and the material layer is formed on the substrate in part while the substrate is in the first position and in part while the substrate is in the second position. The two positions may be provided by moving the substrate and/or the target to change the spacing therebetween, or two chambers may be provided which locate the substrate at different positions from the target. In one of the positions (16), the target (14) and wafer (12) are separated by a long throw distance, which allows for the filling of narrow or high aspect ratio holes in the upper layer of the substrate but also deposits an uneven layer (40) across the face of the substrate. In the second position (18), the substrate (12) is positioned adjacent the target (14), and a deposition layer (43) complementary to that provided in the long throw position is formed on the substrate to provide a uniform layer across the face of the substrate.

## Description

The present invention relates to the deposition of material layers onto substrates by sputtering. More particularly, the present invention relates to the deposition of material layers by sputtering wherein high aspect ratio apertures such as holes or trenches in the upper surface of the substrate are to be filled by the material layer deposited on the substrate, and wherein the deposited layer ultimately formed on the substrate should be planarized and of uniform thickness.

Sputtering is a well known method of depositing a film on a semiconductor substrate. A typical sputtering apparatus includes a vacuum chamber that encloses a target and a substrate support pedestal. The target is typically affixed to the top of the chamber, but is electrically isolated from the chamber walls. A voltage source maintains the target at a negative voltage with respect to the electrically grounded walls of the chamber, to excite a gas, maintained in the chamber at a low pressure, into a plasma. Ions from this plasma sputter the target. As target particles are sputtered from any point on the target, their trajectories have a cosine angular distribution; that is, the density of the sputtered particles ejected from a point on the target along a trajectory having a given angle from perpendicular to the target is proportional to the cosine of such angle. The target particles sputtered from the target generally travel in a straight line path and will tend to deposit on any surface which they contact.

One application of sputtering is the filling of holes and trenches in a dielectric layer on a substrate to form plugs and interconnects. Preferably, the metal film should form a continuous coating of uniform thickness over the entire surface of the dielectric layer, and completely fill any holes or trenches extending through the dielectric layer. The metal film may then be masked and etched to form isolated metal interconnects on the substrate that extend above the base of the hole or trench by a height that approximately equals the sum of the thickness of the metal film deposited on the dielectric layer and the depth of the hole or trench. To ensure that each interconnect formed on the substrate has the same electrical properties, the thickness of the metal film layer deposited on the substrate must be uniform over the entire surface of the substrate, and the holes or trenches must be completely filled. If the metal film thickness is non-uniformly deposited across the surface of the substrate, the height, and thus the electrical resistance, of the interconnects created at different locations on the substrate will be non-uniform. If the holes or trenches are not completely filled, voids will form. Such non-uniformities and voids can cause defects in the semiconductor being manufactured.

One method of filling high aspect ratio holes and trenches with a sputtered deposition layer is to space the substrate a substantial distance from the target, at least as far from the target as the diameter of the substrate. Where the substrate is so spaced, most of the target particles having trajectories that are substantially non-perpendicular to the face of the substrate are deposited on the shields or side walls of the chamber before they can reach the substrate. Those target particles which do reach the substrate have substantially perpendicular trajectories with respect to the face of the substrate, and will thus tend to form a continuous film layer on the base and walls of the hole or trench. Over time, the film layer will grow to fill the hole or trench. This sputtering configuration is known as long throw sputtering.

Long throw sputtering has two primary disadvantages. The first disadvantage is the substantial quantity of target material that is wasted by being deposited on the shields or side walls of the chamber rather than on the substrate surface. The second disadvantage is that long throw sputtering deposits a film which is thicker at the center of the substrate than at the edge of the substrate.

A second method of filling high aspect ratio holes in a dielectric layer is to place a collimator between the target and the substrate. The collimator is a plate having a plurality of apertures extending therethrough which are aligned in a generally perpendicular relationship to the substrate. As target particles pass into the area of the collimator, only those particles traveling substantially perpendicular to the substrate will pass through the apertures in the collimator. Thus, a relatively uniform collimated stream of target particles will travel downwardly from the collimator to fill the base and sides of the holes. However, most of the particles sputtered from the target will deposit on the sides of the chamber, on shields disposed between the target and the collimator, on the upper face of the collimator or on the sides of the collimator apertures. It should be appreciated that a substantial quantity of the target particles sputtered from the target are wasted by being deposited on the surfaces of the collimator. Additionally, the collimator apertures quickly fill with deposited particles, which particles block the apertures and reduce the aperture width. Eventually the particles will completely fill the apertures and the collimator must be replaced.

A third method of filling high aspect ratio holes in a dielectric layer, which is disclosed in United States Patent No. 5,171,412, Talieh, et. al., includes the steps of placing a collimation plate between the target and the substrate to provide a collimated stream of target particles to deposit a first metal sub-layer on a substrate, and then providing a non-collimated source of target particles to deposit a second metal sub-layer over the first metal sub-layer. The substrate is maintained at a reflow temperature as the second metal sub-layer is deposited. The first metal sub-layer forms a seed layer on the base and sidewalls of the holes or trenches, and the second metal sub-layer is deposited on this seed layer to form a full thickness deposition layer. By depositing the second metal sub-layer at the reflow temperature, the second metal sub-layer may reflow to fill the holes or trenches in the substrate. The seed layer formed by the first metal sub-layer provides a continuous metal surface upon which the second metal sub-layer may reflow.

The two step deposition method disclosed in United States Patent No. 5,171,412, Talieh, et al., has several inherent limitations. First, after the first metal sub-layer is formed on the substrate, the collimation plate must be moved or removed from the chamber, or the substrate must be moved to a second chamber, to provide the non-collimated source to deposit the second sub-layer on the substrate. Thus, multiple chambers must be provided to form the complete deposition layer, or manipulators must be provided to move the collimation plate out of the path of the sputtered material travelling from the target to the substrate. Additionally, the collimation plate must be periodically cleaned, or replaced, to maintain the efficiency of the collimation plate.

The present invention provides apparatus and methods for sputter depositing a film on a substrate with improved deposition layer thickness uniformity, while enabling void free filling of holes or trenches. The deposition layer is formed on the substrate in multiple sub-layers, wherein each sub-layer is formed on the substrate at a different distance from the target.

In one aspect of the invention, a layer of material is deposited in two steps on a semiconductor substrate surface having holes or trenches. In step one, a first sub-layer is sputter deposited while the substrate is positioned at a "long throw" distance from the sputtering target. The deposition is performed long enough so that the first sub-layer forms a continuous film covering the walls and base of each hole and trench, but not long enough to completely fill the holes and trenches. In step two, the substrate is positioned substantially closer to the target, and a second sub-layer is sputter deposited to fill the remaining unfilled volume of the holes and trenches. This two step process attains much of the void-free step coverage of a long throw or collimated sputtering process, but without the waste of target material that would occur if the entire process were performed at a long throw sputtering distance or with a collimator.

Preferably, the first step is performed at a temperature too low for the deposited naterial to reflow, but the second step is performed at a temperature high enough to cause reflow of the deposited material. This preferred process attains superior step coverage to a process which does not include reflow, but avoids any problem of voids which could occur if the substrate were heated to reflow temperatures before a continuous initial sub-layer was deposited.

In a second aspect of the invention a substrate is located on a support member and positioned in a first position with respect to the target. The first position is selected to deposit a continuous first deposition material layer on the uppermost layer of the substrate and on the walls and base of the holes or trenches therein. The second position is selected to deposit a second deposition layer on the substrate that has a complementary profile to the profile of the deposition layer formed on the substrate at the first position, and to fill the remaining unfilled volume of the holes or trenches. This complementary deposition layer deposits less material in areas of the substrate where the first material layer is thickest, and more material in areas of the substrate where the first material layer is thinnest.

The multiple deposition layers may be formed in the same chamber, or the substrate may be shuttled between multiple chambers, to form material layers on the substrate at different distances from the target in each of the chambers. Additionally, the substrate may be moved between the first position and the second position as the target is sputtered, to continuously form a deposition layer on the substrate as the distance between the substrate and target is changed.

These, and other features and advantages of the invention will be apparent from the description of the embodiments, when read in conjunction with the following drawings, wherein:
Figure 1 is a diagrammatic illustration of the essential portions of the sputtering apparatus of the present invention;
Figure 2 is a sectional view of the target structure of the present invention showing an exemplary target erosion profile;
Figure 3 is a sectional view of a substrate on the support member of Figure 1 after sputtering at the first location showing an exaggerated view of the deposition layer formed thereon;
Figure 4 is a partial sectional view of a substrate processed in the apparatus of the present invention, showing the profile of the deposition layer formed in a hole or trench of the substrate of Figure 3;
Figure 5 is a diagrammatic illustration of the essential portions of the sputtering apparatus of Figure 1, wherein the substrate has been positioned at a second position closer to the target;
Figure 6 is a sectional view of a substrate on the support member of Figure 2 after sputtering at the second position showing an exaggerated view of the deposition layer formed thereon; and

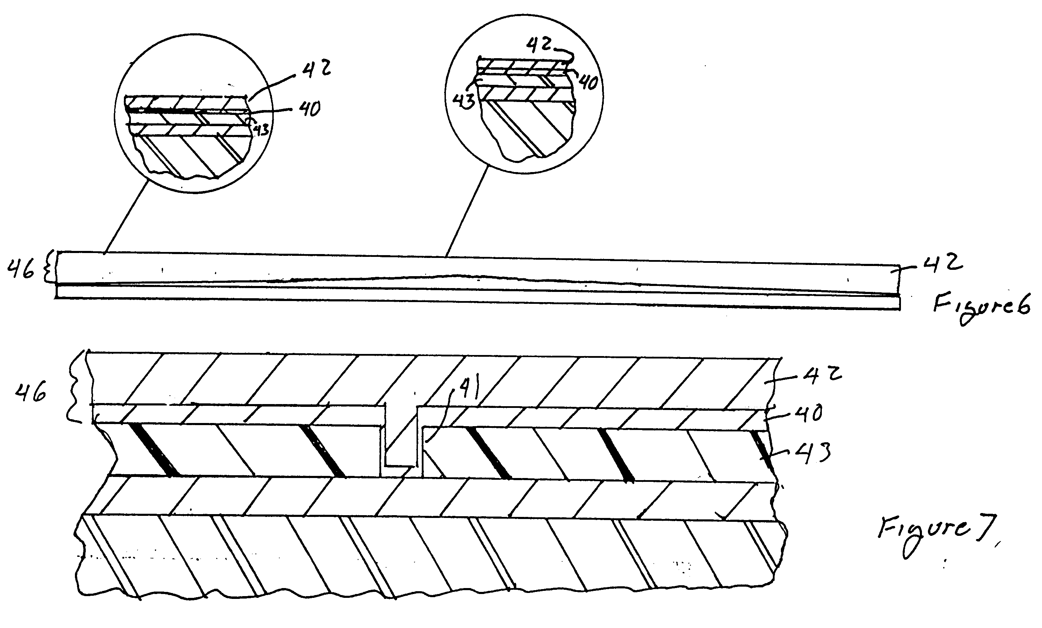

Figure 7 is a partial sectional view of a substrate processed in the apparatus of the present invention, showing the profile of the deposition layer formed in a hole or trench after processing of the substrate at the position shown in Figure 5.

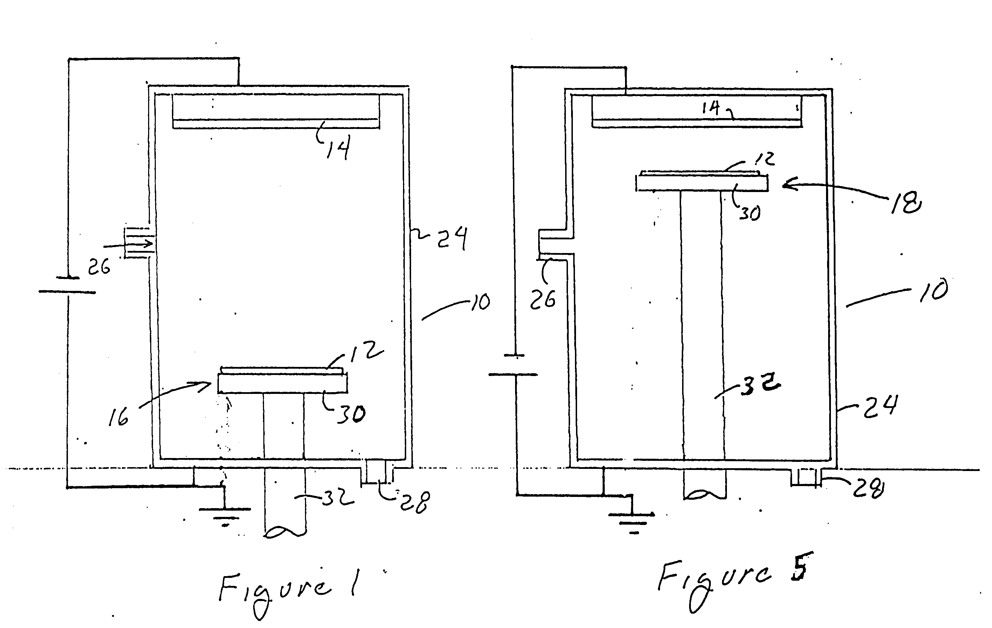

Referring to Figures 1 and 5, the sputtering technique of the present invention generally contemplates the positioning of a substrate 12 in at least two positions with respect to a sputtering target 14, and sputtering the target 14 to deposit a material layer, or film, on the substrate 12 when the substrate 12 is located in each of the two positions. The two positions are selected to form complementary deposition thickness profiles on the substrate so that the final layer deposited on the substrate 12 has a uniform thickness, and to provide complete filling of high aspect ratio holes or trenches in the uppermost dielectric layer of the substrate 12.

The sputtering apparatus of the preferred embodiment of the invention includes a conventional vacuum chamber 10 having a conventional target 14 suspended therein. One suitable sputtering chamber and target is disclosed in United States Patent Number 5,242,566, *Parker*, the disclosure of which is fully incorporated herein by reference. To implement the present invention, the otherwise conventional apparatus must additionally include a mechanism, described below, for adjusting the distance between the substrate 12 and the target 14 at which sputtering can be performed.

The substrate 12 is received in the chamber 10 and positioned for deposition of a sputtered material layer, or film, thereon at a first position 16 as shown in Figure 1 and at a second position 18 as shown in Figure 5. The target is comprised of the material to be deposited on the substrate 12, such as Al, Ti, Ta or W in pure or alloy form. In the tested embodiment, an aluminum target was used to deposit an aluminum film on the substrate 12. The deposition metal film can, if desired, be deposited over one or more dielectric, metal or other layers previously formed on the substrate, and may fill holes or trenches in the dielectric or other layer to form a plug or interconnect.

The vacuum chamber 10 conventionally includes a chamber enclosure wall 24, having at least one gas inlet 26 and an exhaust outlet 28 connected to an exhaust pump (not shown). A substrate support pedestal 30 is disposed at the lower end of the chamber 10, and a target 14 is received at the upper end of the chamber 10. The target 14 is electrically isolated from the enclosure wall 24, and the enclosure wall 24 is preferably grounded, so that a negative voltage may be maintained on the target 14 with respect to the grounded enclosure wall 24. The substrate support pedestal 30 is selectively heated by conventional means, such as by an internal electrical resistance wire heater, and the substrate receiving portion of the substrate support pedestal 30 preferably includes a groove or grooves therein into which a heat conducting gas may be supplied. One such substrate support pedestal 30 configuration is described in United States Patent No. 5,228,501, *Tepman,* et al., which is fully incorporated herein by reference.

During the deposition process a gas, typically a non-reactive species such as Ar, is charged into the vacuum chamber 10 through the gas inlet 26 at a selected flow rate regulated by a mass flow controller valve (not shown). The pressure within the chamber 10 is regulated by controlling the rate at which the chamber gases are pumped through the exhaust outlet 28.

A D.C. power supply applies a negative voltage on the target 14 with respect to the electrically grounded enclosure wall 24 so as to excite the gas into a plasma state. Ions from the plasma bombard the target 14 and sputter particles of target material from the target 14.

A conventional magnetron sputtering source employs a magnet (not shown) above the target 14 to increase the ion concentration adjacent the target 14, and particularly in an annular region intermediate the center and the perimeter of the target 14. As shown by the erosion profile of the target 14 shown in Figure 2, a greater flux of target particles is ejected from an annular region adjacent the perimeter of the target 12 than from the remainder of the target 12. Conventionally, the target is supplied to the chamber with a planar sputtering surface 15, as shown in phantom in Figure 2, As substrates 12 are sequentially processed with the target 14, the target takes on the erosion profile 17 as is also shown in Figure 2. The particles sputtered from the target 14 travel from the target 14 and attach to the exposed surfaces within the chamber 10, including the substrate 12.

In preparation for the deposition process, the substrate 12 is carried into the chamber 10 through a load lock (not shown) in the enclosure wall 24, and positioned within the chamber 10 by a conventional robot arm, blade or other device (not shown) to be received on the support pedestal 30. conventionally, the support pedestal 30 has a retracted position below the position at which the substrate 12 enters the chamber 10, and the support pedestal 30 moves upwardly in the chamber 10 to lift the substrate 12 off the robot arm, blade or other device which locates the substrate 12 in the chamber 10. The support pedestal 30 conventionally is moved by a hydraulic ram, a lead screw system, or other such elevator mechanism, which is preferably maintained on the exterior of the enclosure wall 24 and coupled to the support pedestal 30 by a rod 32 extending through a sealed opening in the base of the enclosure wall 24.

Once the substrate 12 is received on the support pedestal 30, the support pedestal 30 is raised by the previously mentioned elevator mechanism to locate the substrate 12 at a first "long throw" position 16 which is a "long throw" distance from the target 14.

A "long throw" distance, shown in Figure 1, is defined as a distance great enough that those target particles which contact the substrate 12 are travelling substantially perpendicular to the substrate 12. At the "long throw" distance, the deposition layer formed at the center of the substrate is thicker than the deposition layer formed at the edge of the substrate, because all areas of the target can contribute deposition material to the center of the substrate 12, but only those areas of the target 14 directly above the edge of the substrate 12 contribute material particles to the deposition layer formed at the edge of the substrate 12. Therefore, at the long throw distance, a material sub-layer 40 is formed that is thickest at the center of the substrate 12 and thinnest along the edge of the substrate 12 as shown in Figure 3. During the formation of this first deposition material sub-layer 40, the substrate support pedestal 30 may be heated, but no gas is flowed between the substrate 12 and the substrate support pedestal 30, and thus the substrate 12 does not become heated by the substrate support pedestal 30 as the first deposition material sub-layer 40 is formed. The substrate 12 is maintained at a temperature substantially below the reflow temperature of the material being deposited to prevent the material from reflowing as it is deposited on the substrate to ensure that the first material sub-layer 40 forms a continuous seed layer over the exposed surfaces of the substrate, including the base and walls of any holes or trenches therein. The first material sub-layer 40 is continuous in that no gaps, or minimal gaps, exist in the film layer, although it is specifically contemplated that the film layer may have a variable thickness.

Referring to Figure 4, an exemplary hole 41 in a dielectric layer 43 is shown which may be filled using the apparatus of the present invention. The target particles travelling generally perpendicular to the substrate 12 will deposit a generally uniform film layer on the wall and base of the exemplary hole 41 in the dielectric layer 43 on the substrate 12, without creating a material overlap at the upper end of the exemplary hole 41. For example, where the exemplary hole 41 is 1.0 to 1.2 µm deep, and 0.5 µim wide, a first deposition material sub-layer 40 0.3 µm thick on the outer surface of the dielectric layer 43 will provide a continuous seed layer, at least approximately 0.06 µm thick over the wall and base of the exemplary hole 41 without forming an overhang at the opening of the exemplary hole 41. Additionally, a 0.06µm thick deposition layer is sufficient to provide a continuous film layer over the uppermost surface of the substrate 12 and the side and base of the exemplary hole 41.

After the first material sub-layer 40 is deposited on the substrate 12 at a thickness sufficient to form a continuous deposition layer on the wall and base of the holes in the dielectric layer, the substrate 12 is moved by the support pedestal 30 to the second closer position 18 as shown in Figure 5. Sputtering is preferably stopped as the substrate 12 is moved in the chamber 10, and a gas is supplied to the backside of the substrate through the groove in the substrate support pedestal 30 to increase the heat transfer between the substrate 12 and the substrate support pedestal 30 as the substrate 12 is moved from the first position 16 to the second position 18. This gas will transfer heat from the substrate support pedestal 30 to raise the temperature of the substrate 12 to approximately 450°C, the reflow temperature of aluminum.

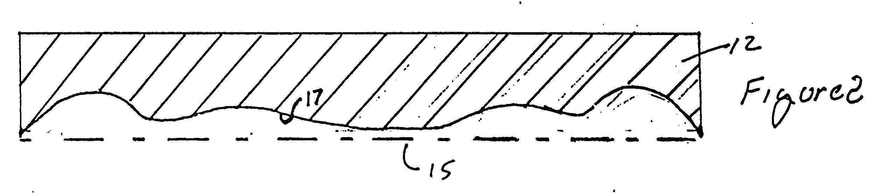

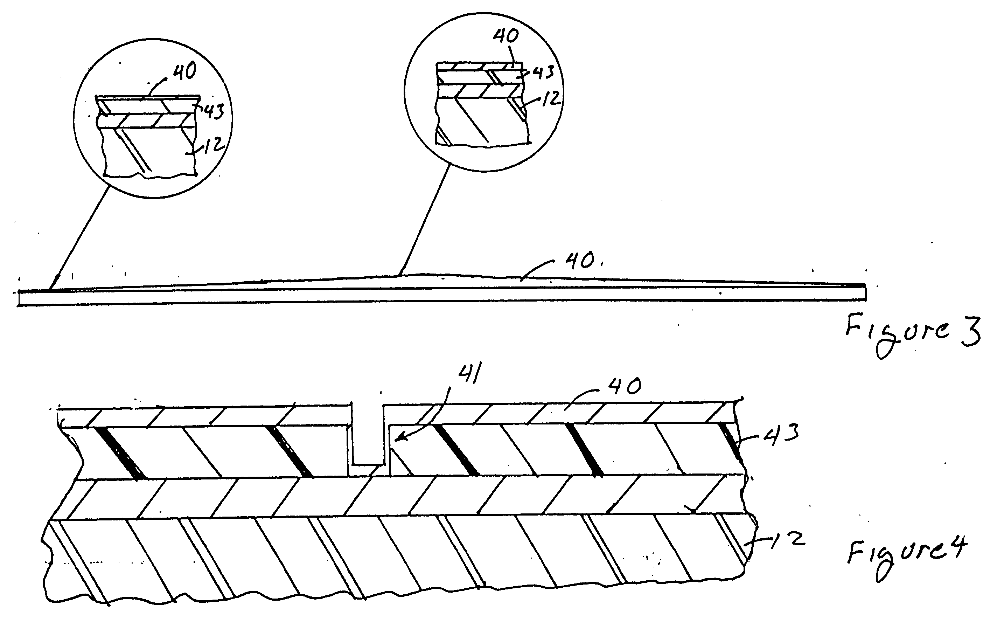

The second position is selected to provide a second material sub-layer 42 that has a complementary thickness profile to that of the first material sub-layer 40. This complementary thickness second sub-layer 42, when combined with the first sub-layer 40, will yield a uniform overall material layer 46 as shown in Figure 6. Specifically, the sub-layer 40 deposited in the first step is thicker at the center of the substrate 12 as explained above, and the sub-layer 42 deposited in the second step is thicker at the edge of the substrate 12 because the magnet behind the target 14 causes a higher plasma density, and thus a higher sputtering rate, near the perimeter of the target 14. Where the target erosion profile is that shown in Figure 2, and the first material sub-layer 40 was formed at a spacing between the target 14 and substrate 12 of approximately one and one-half times the diameter of the substrate, the second position 18 is preferably closer to the target 14 than one-half the diameter of the substrate 12, preferably at a distance of forty percent of the diameter of the substrate 12.

Once the substrate 12 is located in the second position 18 and heated to an acceptable temperature, the target 14 is sputtered to form the second material sub-layer 42 over the first material sub-layer 40. As the second material sub-layer 42 forms on the substrate 12, a portion of the target particles deposit directly over the portion of the first material sub-layer 40 that formed a film over the base and sides of the exemplary hole 41. Additionally, at the elevated substrate temperature, atoms of the second material sub-layer 42 migrate within the second material sub-layer 42 to additionally fill the exemplary hole 41. These migrating atoms, in addition to the target particles reaching the substrate 12, will fill the remaining unfilled volume of the holes and thus yield a planarized deposition layer. For example, where the exemplary hole 41 is 1.2µm deep, 0.5µm wide, and a 0.3µm aluminum layer was formed on the dielectric layer 43 at the first position, an additional 0.5µm deposition layer deposited over the first material sub-layer 40 at the second position 18 will provide desirable hole filling and form a complimentary uniform overall deposition layer thickness 46. Additionally, because the substrate 12 is located substantially closer to the target 14 in the second position 18 than in the first position 16, in the second position 18 a greater percentage of the particles sputtered from the target 14 deposit on the substrate 12 rather than on the shield or chamber walls as occurs in the first position 16.

Although specific locations are set forth herein for the spacing between the substrate 12 and the target 14, the distance between the first position 16 and the target 14 may be varied to provide, and optimize, the improvements in hole filling and deposition layer uniformity of the present invention for different magnetic field profiles and target erosion profiles, and for different substrate 12 and chamber 10 geometries. However, the first position 16 must be selected as a long throw distance in order to provide the hole or trench wall and base coverage characteristics of the present invention. Therefore, the location of the second position 18 is primarily selected to provide a deposition sub-layer 42 thickness that is complimentary to that provided by the first deposition sub-layer 40.

Although the invention has been described in terms of the substrate 12 being moved between the first position 16 and the second position 18 within a single chamber 10, the invention specifically contemplates the use of two chambers to provide the improvements of the present invention. In the two chamber configuration, the first material sub-layer 40 is sputtered on the substrate 12 while the substrate 12 is maintained at the first position 16 in one of the chambers, and the second material sub-layer 42 is sputtered on the substrate 12 while the substrate 12 is maintained at the second position 18 in the second chamber. Additionally, the sub-layers 40, 42 may be deposited on the substrate 12 in a chamber wherein the target 14, or both the target 14 and the substrate 12, may be moved to provide the different spacings between the target 14 and the substrate 12 to provide the improvements in hole filling and material layer uniformity of the present invention.

As described herein, the present invention provides improved deposition layer uniformity and filling of high aspect ratio holes or trenches, and as an additional benefit, allows for greater utilization of the target material than is possible with complete long throw or collimated sputtering, or that is possible with a combination of collimated and standard sputtering as described in U.S. Patent No. 5,171,412, Talieh, et al. By eliminating the collimator, a portion of the quantity of target material which would be deposited on the collimator is deposited on the substrate 12. Further, by performing a portion of the deposition layer formation with the substrate 12 in close proximity to the target 14, a greater percentage of the particles leaving the target 14 surface will be deposited on the substrate 12 than would be deposited on the substrate 12 if the substrate 12 was maintained entirely in the long throw position. Therefore, the present invention also provides improvements in the utilization of the target 14.

## Claims

1. An apparatus for depositing material sputtered from a target onto a substrate, comprising:
at least one evacuable enclosure having the target received therein; and
a substrate support member disposed within the enclosure to receive and support the substrate thereon, said support member having a first position with respect to the target to position the substrate for the deposition of a continuous first sub-layer of material thereon, and a second position with respect to the target to position the substrate for the deposition of a second sub-layer of material thereon.

2. The apparatus of claim 1, wherein said second position is intermediate said first position and the target.

3. The apparatus of claim 1, wherein said first position is a long throw distance from the target.

4. The apparatus of claim 1, wherein said substrate support member moves with respect to the target to position the substrate in the first position and the second position.

5. The apparatus of claim 1, further including a second evacuable enclosure having a second target therein, wherein the substrate is positioned in the second position in the second evacuable enclosure.

6. The apparatus of claim 1, wherein said first sub-layer of material and said second sub-layer of material combine to form a uniform thickness deposition layer.

7. The apparatus of claim 1, wherein the substrate includes at least one aperture having a wall and a base extending inwardly of the uppermost surface of the substrate.

8. The apparatus of claim 1, wherein the chamber includes a heating member, and said substrate support member may be heated to the reflow temperature of the deposition material when the substrate is positioned in said second position.

9. A method of forming a deposition layer on a substrate in a sputtering apparatus, comprising:
providing a sputtering chamber having a target therein;
providing a moveable substrate support member in said sputtering chamber;
locating the substrate on the substrate support member;
moving the substrate support member between multiple positions within the chamber to form a continuous deposition material sub-layer on the substrate and then continue depositing sputtered material on the substrate to form the deposition layer.

10. The method of claim 9, wherein the step of moving the substrate support member is continuous as the deposition layer is formed on the substrate.

11. The method of claim 10, wherein the substrate support member moves toward the target as the deposition layer is formed on the substrate.

12. The method of claim 9, wherein the multiple positions include a first position and a second position, and the continuous deposition material sub-layer is formed on the substrate in the first position.

13. The method of claim 12, wherein the first position is a long throw distance from the target.

14. The method of claim 13, wherein the deposition layer formed at the first position has a non-uniform thickness, and the second position is selected to provide a complementary deposition layer to the deposition layer formed on the substrate at the first position.

15. The method of claim 14, wherein the deposition layer formed at the first position is thicker at the center of the substrate, and the deposition layer formed at the second position is thicker at the edge of the substrate.

16. The method of claim 13, wherein the substrate includes at least one aperture therein having a wall and a base, and the deposition material sub-layer forms a continuous film over the wall and base of the aperture.

17. The method of claim 16, wherein the substrate is heated to an elevated temperature at the second position, and the material layer formed on the substrate at the second position reflows to fill the aperture.

18. A sputtering apparatus for depositing multiple complementary deposition layers on a substrate, comprising:
a vacuum chamber enclosing a sputtering target and a moveable substrate support pedestal, wherein said pedestal may be positioned at a first position with respect to the target to form a material layer on the substrate that is thickest at the center of the substrate, and the pedestal may be positioned at a second position with respect to the target to form a material layer on the substrate that is thickest adjacent the edge of the substrate.

19. The sputtering apparatus of claim 18, wherein said second position is a long throw distance from the target.

20. The sputtering apparatus of claim 18, wherein the substrate includes at least one aperture therein having a wall and base, and the deposition layer formed at the first position forms a continuous layer on the wall and base of the aperture.

21. The sputtering apparatus of claim 20, wherein said aperture has an aspect ratio of at least 1.5.
